# EUROPEAN PATENT SPECIFICATION

(11) **EP 0 369 676 B1**
(45) Date of publication and mention of the grant of the patent: **08.11.1995**
(21) Application number: 89311579.0
(22) Date of filing: 09.11.1989
(51) Int. Cl.: H01L 29/788, G11C 17/00

(54) **Semi-conductor non-volatile memory**
Nichtflüchtige Halbleiterspeicheranordnung
Mémoire non volatile à semi-conducteur

(30) Priority: 17.11.1988 JP 19880290547; 20.07.1989 JP 19890188069; 21.07.1989 JP 19890190185
(43) Date of publication of application: 23.05.1990
(73) Proprietor: SEIKO INSTRUMENTS INC., Tokyo 136 (JP)
(72) Inventor: Kojima, Yoshikazu, Koto-ku Tokyo (JP)
(74) Representative: Caro, William Egerton

(56) References cited:
- US-4 622 656
- GB-2 200 795
- US-4 267 558
- PATENT ABSTRACTS OF JAPAN, vol. 10, no. 24 (E-377)[2081], 30th January 1986; & JP-A-60 182 777 (KOGYO GIJUTSUIN) 18-09-1985
- IEDM Dig. Techn. Papers, pp. 38-41 (1980) : "Limiting Factors for Programming EPROM of Reduced Dimensions", by M. WALD et al.

## Description

The present invention relates to a semi-conductor non-volatile memory of the floating gate type for use in electronic instruments such as computers.

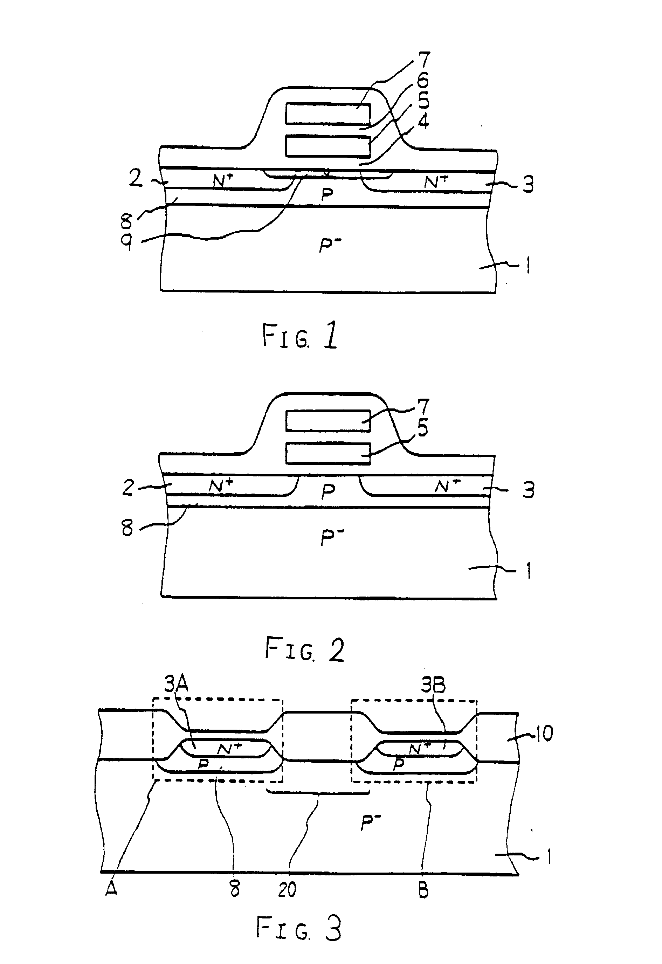

A conventional semi-conductor non-volatile memory of the floating gate type, which is erasable by ultra-violet radiation, is shown in Figure 2 and is constructed such that a source region 2 of N⁺ type and a drain region 3 of N⁺ type are formed in a surface of a P type semi-conductor substrate 1. A floating gate electrode 5 is formed over a channel region in the semiconductor substrate surface between the source region 2 and the drain region 3, the floating gate electrode 5 being covered with an electrically insulating film. Such a memory is disclosed, for example, in M. Wada et al, "Limiting Factors for Programing EPROM of Reduced Dimensions" in IEDM Dig. Tech Papers, pages 38 to 41 (1980).

Further prior art non-volatile memory devices are disclosed in JP-A-60-182 777.

In the conventional semi-conductor non-volatile memory as shown in Figure 2, the substrate 1 has formed in the surface thereof an impurity doped region 8, having an impurity density higher than that of the substrate, so as to reduce programming time and to separate individual memory cells from one another. The memory thus has a high threshold voltage, of about 1.5 V, after erasure by ultra-violet irradiation and therefore operation is difficult in a low voltage range.

An object of the present invention is to provide a semi-conductor non-volatile memory, which is operable by a low drive voltage at a high speed, while maintaining the programming performance and the memory cell separation.

This and further objects are solved by the semi-conductor non-volatile memory according to the appended claims.

According to the invention, therefore, as described below, a first impurity doped region of relatively high density is formed in the substrate to ensure the programming performance and cell separation, and another impurity doped region of opposite conductivity type is formed within the first mentioned impurity doped region so as to reduce the threshold voltage after erasing by ultra-violet radiation, for example to about 0.7 V, to realise a low voltage, high speed operation.

The invention is described further, by way of example, with reference to the accompanying drawings, in which:-
Figure 1 is a sectional view showing a first embodiment of semi-conductor non-volatile memory according to the present invention, taken in the direction of the length of a channel region of the memory;
Figure 2 is a sectional view of a conventional semi-conductor non-volatile memory;
Figure 3 is another sectional view of the first embodiment of the present invention, taken in the direction of the width of the channel region of the memory and showing two adjacent memory cells in a memory cell array of the memory;
Figure 4 is a sectional view showing a second embodiment of semi-conductor non-volatile memory according to the present invention;
Figure 5 is a graph showing impurity distribution in a channel region of the semi-conductor non-volatile memory along the line A - A' of Figure 4;
Figure 6 is a graph illustrating dependency of threshold voltage of the semi-conductor non-volatile memory of Figure 4 on arsenic ion doping quantity; and
Figure 7 is a sectional view showing a third embodiment of semi-conductor non-volatile memory according to the present invention.

The following description is of embodiments of the present invention featuring an ultra-violet-ray-erasable semi-conductor non-volatile memory of N type.

Figure 1 shows a section through a first embodiment of the present invention. The memory comprises a P type silicon substrate 1, which has formed in a surface thereof an impurity doped region 8 having an impurity density higher than that of the substrate 1. Further, a region 9 inside the impurity doped region 8 is doped with an N type impurity at a relatively low density. A floating gate electrode 5 is formed over the impurity doped regions 8 and 9 on a gate oxide film 4, and a control gate electrode 7 is formed over the floating gate electrode 5 on a control gate insulating film 6. A source region 2 and a drain region 3 of N⁺ type are formed at a distance from one another in the substrate surface under the floating gate electrode 5. In this construction, the control gate electrode 7 is strongly capacitively coupled to the floating gate electrode 5 through the control gate insulating film 6, whereby a voltage applied to the control gate electrode 7 indirectly controls the electric potential of the floating gate electrode 5.

A reading operation for the semi-conductor non-volatile memory of Figure 1 will now be described. While a given constant voltage is applied to the control gate electrode 7, impedance is detected in a channel region defined between the source region 2 and the drain region 3 in the surface of the semi-conductor 1 so as to read out information. Namely, when the floating gate electrode 5 is injected with a great number of electrons, the impedance in the channel region is high. On the other hand, when the floating gate electrode is not injected with electrons, for example following erasure by ultra-violet radiation, the impedance is low. Consequently, the impedance according to whether or not the floating gate electrode 5 is injected with electrons indicates the information. Namely, the information is memorised in the form of electrons in the floating gate electrode 5, and therefore is not volatile during normal operation and in the storage state.

When changing or re-writing the information, the memory is irradiated with ultra-violet radiation (hereinafter, referred to as "ultra-violet-ray-erasing") to discharge the electrons from the floating gate electrode to the substrate 1. Thereafter, a voltage is applied to each electrode according to the information to be written or programmed to inject electrons into the floating gate electrode 5 to thereby carry out "programming".

A detailed description is given below of the method of injecting electrons into the floating gate electrode 5, i.e. the method of programming. The source region 2 is held at the same potential as the substrate 1, the drain region 3 is applied with a voltage of 4 V to 10 V and the control gate electrode 7 is applied with a high voltage of 7 V to 14 V. Consequently, a channel current flows between the source region and the drain region, and a part thereof turns to hot electrons and is injected into the floating gate electrode 5. If electrons are not to be injected, one of the drain region 3 and the control gate electrode 7 is held at the same potential as the substrate 1 to avoid injection. The impurity doped region 8 of P type having a high impurity density is formed in the surface of the substrate 1 to facilitate the generation of hot electrons to improve the programming performance.

Figure 3 is a further sectional view of the semi-conductor non-volatile memory, in which a plurality of memory cells are shown arranged in an array and in which individual memory cells are necessarily separated from each other. Namely, as shown in Figure 3, a drain region 3A of a memory cell A is electrically separated from an adjacent drain region 3B of another memory cell B by a separation region 20 composed of a field oxide film 10. The separation region 20 is needed to withstand the high voltage which is applied to the control gate electrode 7 and the drain region 3 of one memory cell when injecting electrons into the associated floating gate electrode 5. For example, when a applying a voltage of about 12.5 V to the control gate electrode 7 of one memory cell to effect the injection of electrons, the separation region 20 must be formed to withstand the voltage of 12.5 V. In the present invention, as shown in Figure 3, the substrate 1 is formed with the high density region 8 of the same conductivity type as the substrate by means of self alignment doping in an active area (which is defined as an area other than the separation region). Stated otherwise, doping is carried out over the substrate surface using the separation region 20 as a mask to form the high density region 8, whereby the separation region 20 is also doped to increase its threshold voltage to ensure the separating characteristic. When using a voltage of about 12.5 V for the programming, the doping for the high density region 8 must be carried out with an ion implantation quantity of more than 2 x 10¹² atoms per cm². Increase of this doping quanity can concurrently improve the separation characteristics.

According to the present invention, the semi-conductor non-volatile memory is constructed so as to enable low voltage operation by diffusing a dopant of N type within the impurity doped region 8 to form therein another impurity doped region 9, rather than by simply reducing the impurity density of the impurity doped region 8 which would hinder the separation characteristic. The region 9 is effective to reduce the surface net impurity density over the channel region so as to set its threshold voltage to about 0. 7 V after ultra-violet irradiation. The introduction of this N type dopant can be carried out in the same step as forming the P type high impurity doped region 8. That is, without adding a photo-lithographic step, N type and P type dopants can be doped into the active area through double ion implantation. However, in order to form the region 9 within or inside the region 8, the N type dopant must be composed of elements having a diffusion co-efficient smaller than that of the P type dopant. For example, the N type dopant may be composed of arsenic and the P type dopant may be composed of boron such that, as shown in Figure 1, the impurity doped region 9 of low net impurity density is formed inside the other impurity doped region 8 of high impurity density.

As described above, while the additional region 9 is formed to lower the threshold voltage of the channel region, sufficient separation between the individual cells can be maintained as shown in Figure 3. Namely, the impurity doped region 8 of P type having a high impurity density overlaps sufficiently the field oxide film 10. More specifically, the region 8 is doped with boron to an ion implantation quantity of more than 2 x 10¹² atoms per cm² to ensure the electrical separation, and the region 9 is doped with arsenic to an ion implantation quantity less than that of the boron to improve the programming performance and provide a memory operable in a low voltage range.

Ion implantation of boron and arsenic can be carried out sequentially in the same photo-lithographic step, thereby avoiding a cost increase due to the addition of another photo-lithographic step. Further, doping with the N type and P type dopants can be efficiently carried out by self alignment doping using the separation region as a mask, further resulting in the above mentioned improvement of the cell separation.

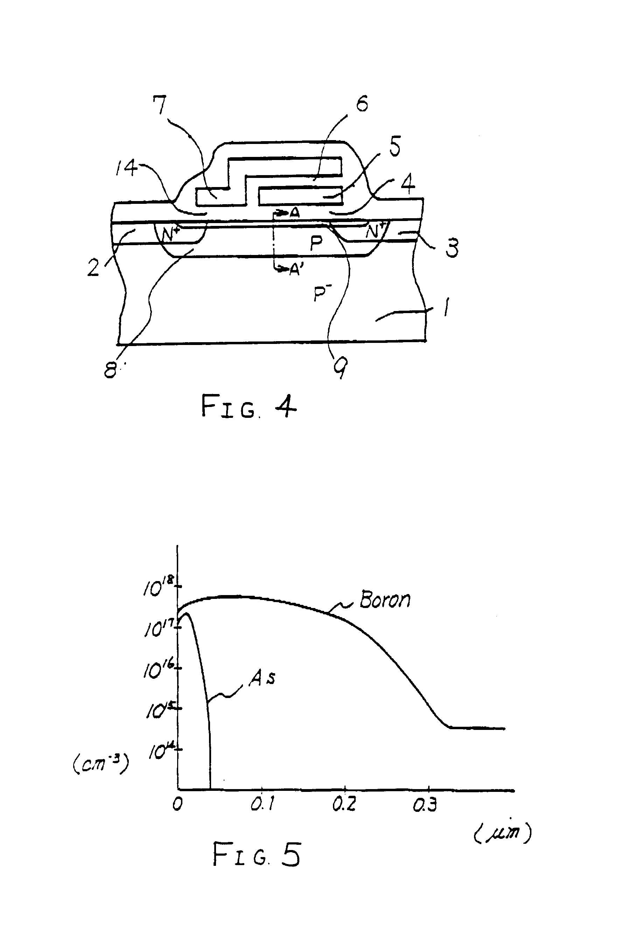

Figure 4 is a sectional view showing a second embodiment of the semi-conductor non-volatile memory. The present semi-conductor non-volatile memory is formed not only in the silicon substrate, but also on a semi-conductor region formed in the substrate as well as on a surface of a semi-conductor film. The memory shown in Figure 4 comprises a P type silicon substrate 1 which has formed thereon a first gate insulating film 4 and a floating gate electrode 5. A control gate electrode 7 has a portion formed on the floating gate electrode 5 on an interlayer insulating film 6 and a portion formed on the substrate on a second gate insulating film 14. A source region 2 and a drain region 3 of N⁺ type are formed in a surface of the substrate 1 by self alignment doping using the floating gate electrode 5 and the control gate electrode 7 as a mask. Further, a first impurity doped region 8 of P type having an impurity density higher than that of the substrate 1 is formed between the source region 2 and the drain region 3 in the surface of the substrate 1 to define therebetween a channel region, and a second impurity doped region 9 containing N type impurity as well as the P type impurity is formed in the surface of the first impurity doped region 8. Generally, the surface density of the P type impurity is set to be greater than that of the N type impurity so that the second impurity doped region 9 is still electrically of P type. Namely, the region 9 contains more P type impurity than N type impurity, in spite of the additional doping of the N type impurity. The first and second impurity doped regions can be formed by ion implantation.

Figure 5 shows a distribution of the impurity density in the vertical direction of the first and second impurity doped regions 8 and 9, namely along line A-A' of Figure 4 from the surface of the substrate 1, when boron is used for the dominant impurity of the first impurity doped region 8 and arsenic is used for the additive impurity of the second impurity doped region 9. Boron and arsenic may be introduced in the same step so that, as shown in Figure 5, the distribution of arsenic is limited to within the boron doped area because arsenic has a diffusion rate smaller than that of boron. Accordingly, the P type impurity is electrically reduced or cancelled on the surface of the channel region by the addition or distribution of the N type arsenic.

The first impurity doped region 8 is effective to satisfy the programming performance of the semi-conductor non-volatile memory in a manner similar to the embodiment of Figure 1 and is effective to raise the threshold voltage of the field oxide film between the memory cells thereby to separate the memory cells electrically from each other. The surface of the substrate 1 is doped with P type impurity to a quantity of approximately 10¹⁷ atoms per cm³ to form the first impurity doped region 8 for facilitating the generation of hot electrons at the time of programming. The second impurity doped region 9 is formed to reduce the threshold voltage of the memory. The control gate electrode 7 is strongly capacitively coupled to the floating gate electrode 5. Accordingly, the control gate electrode 7 may be applied with a voltage to change indirectly the electric potential of the floating gate electrode 5.

A description will be given of the reading operation for the semi-conductor non-volatile memory of Figure 4. A plurality of memory cells are integrated in the form of a memory array, in which individual memory cells are selected to read information therefrom. In each selected memory cell, while the control gate electrode 7 receives a voltage, which is equal or close to the power supply voltage, the conductance of the channel region between the source region 2 and the drain region 3 is detected to read out the information. The channel conductance is high after irradiation by erasing ultra-violet radiation. On the other hand, the channel conductance is low in the programmed state in which many electrons are injected into the floating gate electrode 5.

In this instance, the channel region is composed of a first channel region, which is controlled by the control gate electrode 7 through the second gate insulating film 14, and a second channel region, which is connected in series with the first channel region and which is controlled by the potential of the floating gate electrode 5 through the first gate insulating film 4. Namely, the channel conductance is determined by the values of the conductance of the first and second channel regions. The conductance of the second channel region varies according to the amount of electrons injected into the floating gate electrode 5 while a constant voltage is applied to the control gate electrode 7. Therefore, the conductance of the channel region between the source region 2 and the drain region 3 may be changed to indicate the information accordingly.

As just mentioned, in the semi-conductor non-volatile memory of Figure 4, the channel region is composed of the first channel region controlled directly by the voltage of the control gate electrode, and the second channel region connected in series with the first channel region and controlled by the potential level of the floating gate electrode 5. Accordingly, the second channel region can be formed so as to set its threshold voltage after ultra-violet-ray-erasing to be sufficiently low, while the first channel region may be formed so as to set its threshold voltage to an enhanced level such that leak current in a non-selected memory cell is reduced. Further, when the drain region 3 is applied with a voltage during the reading operation, the potential level of the floating gate electrode 5 may be raised to increase the channel conductance of the second channel region. In view of this, the first channel region can be formed so as to set its channel conductance to a low level for avoiding leak current in a non-selected memory cell. Moreover, in this second embodiment of the present invention, the drain region 3 may be connected to ground and the source region 2 may be supplied with a power source voltage through a load to read the information in terms of the value of the channel region conductance, thereby realising a more functional memory. That is, the floating gate electrode 5 is not structurally connected to the source region 2, thereby eliminating inadvertent writing during the normal reading operation (soft-writing). Consequently, the entire length of the channel region can be reduced as compared with the conventional memory cell, and the source region 2 can receive a high voltage close to the power supply voltage during the reading operation. The channel conductance can thus have a large value after ultra-violet-ray-erasing of the memory whereby a high speed reading operation may be realised.

Next, a description will be given of the programming operation for this second embodiment of the present invention. When injecting electrons into the floating gate electrode 5 of the memory cell, the drain region 3 is applied with a voltage of about 4 V to 7 V with respect to the source region 2 and the substrate 1. Further, the control gate electrode 7 is applied with a high voltage of about 12 V. The application of such voltages to the drain region 3 and the control gate electrode 7 causes a substantial current of the order of 1 mA to flow through the channel region, thereby generating hot electrons in the vicinity of the drain region 3. A part thereof is injected into the floating gate electrode 5. A non-selected memory cell does not receive a voltage at its control gate electrode 7 so that writing is not effected. Further, the selected memory cells may include some in which the injection of electrons into the floating gate electrode 5 is not required. In such memory cells, while the control gate electrode 7 is applied with a high voltage, the drain region 3 is connected to ground to avoid writing. Thus, it is only when both of the drain region 3 and the control gate electrode 7 are applied with voltages, that electrons are injected into the floating gate electrode 5. The Figure 4 memory has a structure effective to suppress soft-writing and wherein the channel length may be made short. Accordingly, the writing operation can be carried out in an extremely short period of time. Further, in a non-selected memory cell during the writing operation, while the drain region 3 may be applied with a high voltage, the control gate electrode 7 is connected to ground so that the conductance of the first channel region is sufficiently low to prevent leak current within the non-selected memory cell.

The second impurity doped region 9 is formed by the doping of arsenic in the surface of the channel region so as to lower the threshold voltage. This impurity doped region 9 does not impair the programming efficiency of the memory, since the surface potential induced during the writing operation in the vicinity of the drain region 3 to generate the hot electrons is not affected by the doping of arsenic. The reason for this is that the second impurity doped region 9 is formed only in an extremely thin surface portion of the channel region due to the small diffusion rate of arsenic as shown in Figure 5.

In order to reduce the threshold voltage of the channel region, the density of the first impurity doped region 8 could be reduced instead of providing the second impurity doped region 9. However, in such a case, the surface potential effective to generate the hot electrons is changed into a dull shape (flattened), thereby hindering the efficiency of the programming. According to the present invention, therefore, the second impurity doped region 9 is formed in order to maintain programming efficiency and simultaneously to reduce the threshold voltage of the memory.

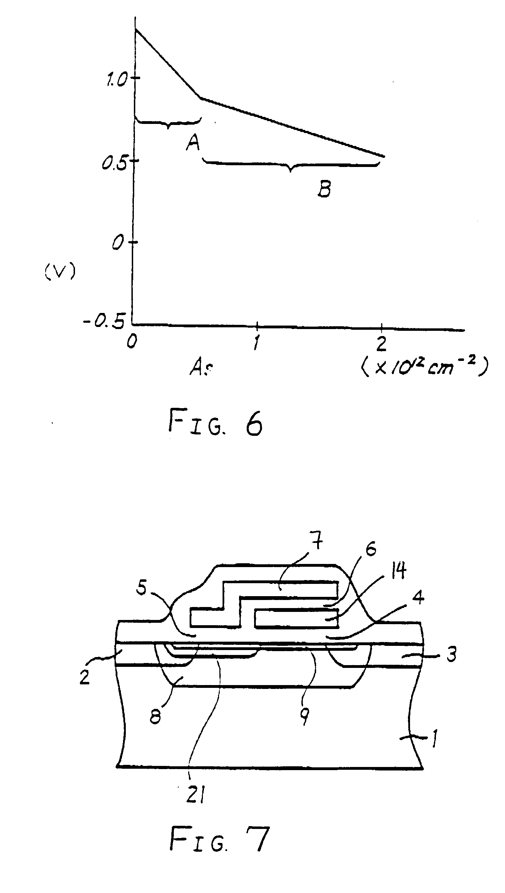

Next, a description will be given of the operation for erasing the memory of Figure 4. The erasing is carried out by irradiating the memory with ultra-violet radiation. The electrons injected into the floating gate electrode 5 are excited by the ultra-violet rays to return to the substrate 1 and thereby effect erasing. Figure 6 shows the dependency of the threshold voltage of the memory after the ultra-violet irradiation on the doping quantity of the arsenic (As). As indicated in Figure 6, the dependency curve is characterised by two parts divided by the critical doping quantity of 5 x 10¹¹ atoms per cm². Namely, the threshold voltage reduces significantly in the part A, and reduces moderately in the part B, as the doping quantity increases. Now, the effective threshold voltage of the memory of Figure 4 is determined by whichever has the greater threshold value of the first and second channel regions. If the second impurity doped region 9 were not present, i.e. the ion implantation quantity of arsenic was zero, the threshold voltage after the ultra-violet-ray-erasing would be determined by the higher threshold voltage of the second channel region. As the doping quantity of arsenic in the second impurity doped region 9 is increased, the magnitudes of the respective threshold voltages of the first and second channel regions are reversed such that the threshold voltage of the first channel region becomes higher than that of the second channel region. In other words, by increasing the doping quantity of arsenic, the effective threshold voltage of the memory is shifted from the part A to the part B of the dependency curve of Figure 6, the part A corresponding to the threshold voltage of the second channel region, and the part B corresponding to the threshold voltage of the first channel region.

In order to reduce the dependency of the threshold voltage of the first channel region on the doping quantity of arsenic in part B, it is possible to set the capacity per unit area of the second gate insulating film 14 to be greater than that of the first gate insulating film 4, since the capacity per unit area of the gate insulating film can be increased to reduce the contribution of the doping quantity of arsenic to the threshold voltage.

In order to reduce the threshold voltage of the memory, the impurity density of the first impurity doped region 8 could be reduced instead of forming the second impurity doped region 9. However, in this case, the threshold voltage of the first channel region would be less than the threshold voltage of the second channel region since the control gate electrode 7 is capacitively coupled to the floating gate electrode 5 not by 100% but normally by about 70%. On the other hand, in the embodiment of the memory shown in Figure 4, the second impurity doped region 9 may be formed so that the threshold voltage of the first channel region is made higher than that of the second channel region, such adjustment of the threshold voltages being carried out by changing the impurity density.

As an alternative, in the Figure 4 memory, the second gate insulating film 14 can be formed of a thermal oxidation film, after removing the first gate insulating film 4, such that a part of the second impurity doped region 9 is integrated into the second gate insulating film 14 in order to reduce the arsenic density of the first channel region. Accordingly, the threshold voltage of the first channel region may be made higher than that of the second channel region in this manner.

Figure 7 is a sectional view showing a third embodiment of semi-conductor non-volatile memory which is similar to the embodiment of Figure 4 and in which like parts are represented by the same reference numerals. By contrast with the Figure 4 embodiment, however, the memory shown in Figure 7 has a third impurity doped region 21 of P type, which is formed in the first channel region by self alignment doping using the floating gate electrode 5 as a mask. Such P type impurity doping serves to cancel the N type impurity in the second impurity doped region 9 so as to set the threshold voltage of the first channel region high.

In the second and third embodiments of semi-conductor memory described above, the second impurity doped region 9 is doped with arsenic to reduce the threshold voltage after ultra-violet-ray-erasing to about 0.5 V. This is the threshold voltage of the first channel region and therefore is stable independently of any voltage applied to the drain region 2, which reduces leak current. Since the threshold voltage can be reduced to about 0.5 V, a power source voltage of at least about 1.0 V can be used to drive the memory. Further, by reducing the threshold voltage, drain current can be increased to enable high speed operation of the memory.

As described above, a semi-conductor non-volatile memory according to the invention of the floating gate type erasable by ultra-violet radiation has a first dopant of the same conductivity type as that of the substrate added into the substrate surface by self alignment doping using the cell separation region as a mask, and another dopant of less diffusible type for doping the substrate surface at a lower density than the doping by the first mentioned dopant. By such means, the threshold voltage of the memory can be lowered to the range of 0.5 V to 1.0 V to provide high speed driving with satisfactory programming performance and cell separation.

## Claims

1. A semi-conductor non-volatile memory comprising a semi-conductor substrate (1) of a first conductivity type, a semi-conductor region (8) of the first conductivity type formed in a surface portion of the semi-conductor substrate and having an impurity density higher than that of the semi-conductor substrate, source and drain regions (2, 3) of a second conductivity type formed in spaced relation in the surface of the semi-conductor substrate, a floating gate electrode (5) formed on and electrically insulated from the semi-conductor region, and a control gate electrode (7) formed on and electrically insulated from the floating gate electrode, **characterised by** a further semi-conductor region (9) formed inside the first semi-conductor region (8) at its surface portion and containing impurity of the second conductivity type, the further semi-conductor region (9) extending between and overlapping both source and drain regions (2, 3).

2. A memory according to claim 1, **characterised in that** the impurity of the further semi-conductor region (9) is less than that of the first semiconductor region (8).

3. A memory according to claim 1 or 2, wherein the control gate electrode (7) includes a section capacitively coupled to the floating gate electrode (5) so as to control indirectly a channel region defined between the source and drain regions (2, 3).

4. A memory according to claim 3, wherein the control gate electrode (7) includes another section formed over and electrically insulated from a part of the channel region so as to control the same directly.

5. A memory according to claim 4, **characterised by** a third semi-conductor region (21), formed under said another section of the control gate electrode (7) and containing impurity of the first conductivity type effective to cancel the impurity of the second conductivity type contained in the further semi-conductor region (9).

## Patentansprüche

1. Nichtflüchtige Halbleiterspeicheranordnung mit einem Halbleitersubstrat (1) eines ersten Leitungstyps, einer Halbleiterzone (8) des ersten Leitungstyps, die in einem Oberflächenteil des Halbleitersubstrats ausgebildet ist und eine gegenüberder Dotierungsdichte des Halbleitersubstrats höhere Dotierungsdichte besitzt, einer Source- und Drain-Zone (2, 3) eines zweiten Leitungstyps, die beabstandet zueinander in der Oberfläche des Halbleitersubstrats vorgesehen sind, einer Floating-Gate-Elektrode (5), die auf der Halbleiterzone und elektrisch isoliert von dieser ausgebildet ist, und einer Steuer-Gate-Elektrode (7), die auf der Floating-Gate-Elektrode und elektrisch isoliert von dieser ausgebildet ist, **gekennzeichnet durch** eine weitere Halbleiterzone (9), die innerhalb der ersten Halbleiterzone (8) an deren Oberflächenbereich ausgebildet ist und eine Dotierung des zweiten Leitungstyps enthält, und daß die weitere Halbleiterzone (9) zwischen der Source- und Drain-Zone (2, 3) verläuft und diese überlappt.

2. Speicher nach Anspruch 1, **dadurch gekennzeichnet, daß** die Dotierung derweiteren Halbleiterzone (9) kleiner als diejenige der ersten Halbleiterzone (8) ist.

3. Speicher nach Anspruch 1 oder 2, in dem die Steuer-Gate-Elektrode (7) einen so kapazitiv an die Floating-Gate-Elektrode (5) angekoppelten Abschnitt enthält, daß eine zwischen der Source- und Drain-Zone (2, 3) definierte Kanalzone indirekt gesteuert wird.

4. Speicher nach Anspruch 3, in dem die Steuer-Gate-Elektrode (7) einen weiteren Abschnitt enthält, der über und elektrisch isoliert von einem Teil der Kanalzone ausgebildet ist, um diese direkt zu steuern.

5. Speicher nach Anspruch 4, **gekennzeichnet durch** eine dritte Halbleiterzone (21), welche unter dem weiteren Abschnitt der Steuer-Gate-Elektrode (7) ausgebildet ist und eine Dotierung des ersten Leitungstyps enthält, die im Sinne der Auslöschung der in der weiteren Halbleiterzone (9) enthaltenen Dotierung des zweiten Leitungstyps wirkt.

## Revendications

1. Une mémoire non volatile à semiconducteurs comprenant un substrat semiconducteur (1) d'un premier type de conductivité, une région de semiconducteur (8) du premier type de conductivité, formée dans une partie de surface du substrat semiconducteur et ayant une concentration d'impureté supérieure à celle du substrat semiconducteur, des régions de source et de drain (2, 3) d'un second type de conductivité, formées de manière espacée à la surface du substrat semiconducteur, une électrode de grille flottante (5) formée sur la région de semiconducteur et électriquement isolée de celle-ci, et une électrode de grille de commande (7) formée sur l'électrode de grille flottante et électriquement isolée de celle-ci, **caractérisée par** une région de semiconducteur supplémentaire (9) formée à l'intérieur de la première région de semiconducteur (8) et dans sa partie de surface, et contenant une impureté du second type de conductivité, la région de semiconducteur supplémentaire (9) s'étendant entre les régions de source et de drain (2, 3) et chevauchant celles-ci.

2. Une mémoire selon la revendication 1, **caractérisée en ce que** la concentration de l'impureté de la région de semiconducteur supplémentaire (9) est inférieure à celle de la première région de semiconducteur (8).

3. Une mémoire selon la revendication 1 ou 2, dans laquelle l'électrode de grille de commande (7) comprend une section en couplage capacitif avec l'électrode de grille flottante (5), de façon à commander indirectement une région de canal qui est définie entre les régions de source et de drain (2, 3).

4. Une mémoire selon la revendication 3, dans laquelle l'électrode de grille de commande (7) comprend une autre section qui est formée sur une partie de la région de canal et est électriquement isolée de celle-ci, dans le but de commander directement cette partie de la région de canal.

5. Une mémoire selon la revendication 4, **caractérisée par** une troisième région de semiconducteur (21) formée sous l'autre section précitée de l'électrode de grille de commande (7) et contenant une impureté du premier type de conductivité qui annule l'effet de l'impureté du second type de conductivité qui est contenue dans la région de semiconducteur supplémentaire (9).
